Europäisches Patentamt

**European Patent Office**

**Office européen des brevets**

(11) Numéro de publication: **0 172 049 B1**

# (12) FASCICULE DE BREVET EUROPEEN

(45) Date de publication de fascicule du brevet: **26.02.92** (51) Int. Cl.⁵: **H05K 13/00**, B25H 1/16

(21) Numéro de dépôt: **85401253.1**

(22) Date de dépôt: **24.06.85**

(54) **Console de travail ergonomique à plateaux mobiles verticalement.**

(30) Priorité: **13.07.84 FR 8411166**

(43) Date de publication de la demande:
**19.02.86 Bulletin 86/08**

(45) Mention de la délivrance du brevet:
**26.02.92 Bulletin 92/09**

(84) Etats contractants désignés:
**AT BE CH DE FR GB IT LI LU NL SE**

(56) Documents cités:
**DE-A- 2 751 856**
**US-A- 3 426 415**

(73) Titulaire: **Toniazzo épouse Tokarczyk, Joséphine**
**15 Rue des Roses**
**F-92160 Antony(FR)**

Titulaire: **Remy, Jacques**
**15 Rue des Roses**
**F-92160 Antony(FR)**

(72) Inventeur: **Toniazzo épouse Tokarczyk, Joséphine**
**15 Rue des Roses**
**F-92160 Antony(FR)**
Inventeur: **Remy, Jacques**
**15 Rue des Roses**
**F-92160 Antony(FR)**

Rank Xerox (UK) Business Services

## Description

La présente invention concerne les tables de travail de surface limitée placées à la disposition d'un opérateur en vue d'y effectuer une suite d'opérations déterminées et elle vise plus particulièrement le garnissage de plaques de circuits imprimés par des composants électroniques avant leur fixation définitive.

Une console selon le préambule de la revendication 1 est par ex. connue du document US-A-3426415.

Les circuits imprimés reçoivent dans des trous prévus à cet effet, les queues des composants électroniques qui dépassent à l'émergence de la face opposée pour y être soudées ce qui assure à la fois leur connexion électrique sur les pistes conductrices imprimées et leur fixation matérielle définitive. Jusqu'à ce jour, ces opérations s'effectuaient sur des tables, ce qui nécessitait une grande surface d'immobilisation horizontale.

Il faut en effet considérer l'ensemble de l'opération qui consiste :
- à disposer les plaques de circuit imprimé sur ledit plan horizontal, côte à côte, la face imprimée étant le verso côté table,
- à introduire chaque composant par ses queues soudables dans chaque trou correspondant,
- à translater lesdites plaques sans à-coup ni secousse vers la machine de soudage,
- à procéder au soudage proprement dit.

Dans les ateliers, les surfaces d'occupation horizontales de préparation de garnissage des composants électroniques peuvent être importantes et en tout cas être l'occasion d'une gêne importante pour le personnel qui doit assurer des travaux précis et fastidieux sur un champ de travail de grande longueur.

Les difficultés sont réelles et conditionnent directement la qualité du travail obtenu.

Si l'on considère que les plaques de circuits imprimés doivent rester rigoureusement planes pendant tout le cycle de garnissage des composants puis, avant la phase de soudage, ne pas subir de secousses afin de ne pas faire sortir accidentellement des queues de leur trou de soudage, il est évident de constater que la recherche de l'automatisation est un souci permanent de ceux qui ont la charge de la production de tels matériels.

Les équipements existants ne donnent pas satisfaction pour diverses raisons :
- certaines tables sont à défilement horizontal ce qui n'exclut pas les à-coups au moment de l'arrêt ou du démarrage de la chaîne ; la surface horizontale restant appréciable,
- d'autres procèdent d'un processus de chaîne verticale mais l'installation est complexe et l'infrastructure toujours importante.

La solution aux problèmes cités ci-dessus est donnée par les caractéristiques de la revendication 1.

A cet effet les demandeurs proposent dans la présente invention, un équipement comportant une table de travail ergonomique à poste fixe où le plan de travail, à surface limitée s'escamote verticalement dans un réceptacle selon un processus de déplacement rigoureusement vertical et sans à-coup ni secousse.

C'est en partant de la constatation qu'un volume disponible apparaît, sur une table de travail, entre le plan de travail et l'emplacement des genoux d'un opérateur normalement assis, que les demandeurs ont été amenés à concevoir le logement d'une pluralité de plateaux de travail dans un caisson ou carénage en forme de console;lesdits plateaux pouvant subir un déplacement vertical d'escamotage et de stockage vers le haut dans un réceptacle disposé à cet effet.

De la sorte,l'opérateur peut travailler confortablement sans fatigue sur chaque plateau dans le plan de travail puis et dès que son ouvrage est terminé sur un plateau,faire translater cedit plateau à l'aide de mécanismes appropriés,dans le réceptacle supérieur et ce,par un mouvement sans à-coup ni aucune secousse.

L'opérateur procéde ensuite de la sorte pour chaque plateau de travail jusqu'à épuisement des plateaux logés dans la console.

Il peut également,toujours à l'aide des mécanismes appropriés,ramener un seul ou la totalité des plateaux logés dans le réceptacle supérieur dans le plan de travail de la console de maniére à pouvoir extraire ainsi chaque plateau en vue de lui faire subir une opération ultérieure qui peut être par exemple le soudage des queues des composants d'un circuit imprimé.

L'invention va donc proposer une table de travail en forme de console présentant les critères ergonomiques requis et qui permet de traiter d'une part, de par la surface appréciable de chaque plateau de travail,une quantité relativement élevée d'unités élémentaires et d'autre part,de par l'accroissement du nombre de plateaux pouvant être logés dans les carénages,un nombre plus élevé d'éléments en un seul cycle de fabrication.

On peut envisager de nombreuses variantes d'opérations compatibles avec la mise en oeuvre de l'invention notamment dans le domaine du laboratoire,de la mécanique de précision,de la pharmacie,de l'électronique...

Il est précisé que l'invention est utile aux handicapés qui peuvent loger leur fauteuil roulant sous la console et qui n'ont plus de déplacements latéraux fastidieux à effectuer.

L'invention va de toutes maniéres être bien comprise dans la suite du texte qui va donner à titre d'exemple non limitatif et à l'appui des dessins annexés,une forme de réalisation prise dans le domaine de l'électronique pour le garnissage en composants de circuits imprimés avant leur soudage destiné à assurer leur fixation et leur continuité électrique.

Sur les dessins:

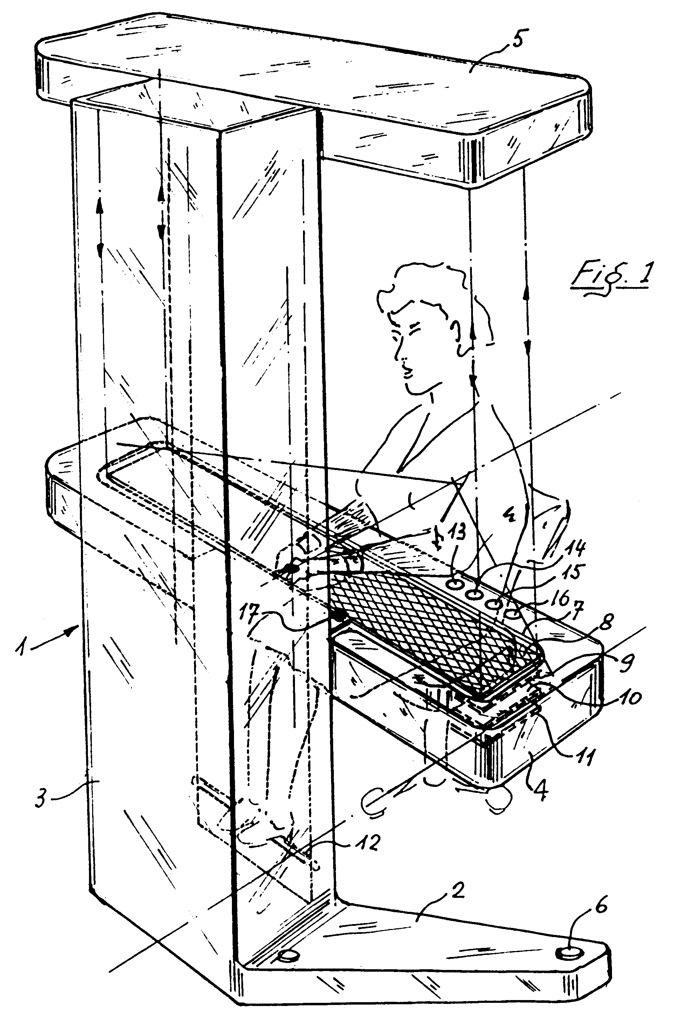

La figure 1 représente en perspective,l'ensemble de la console de travail selon l'invention où une opératrice a été représentée dans une posture ergonomique convenable.

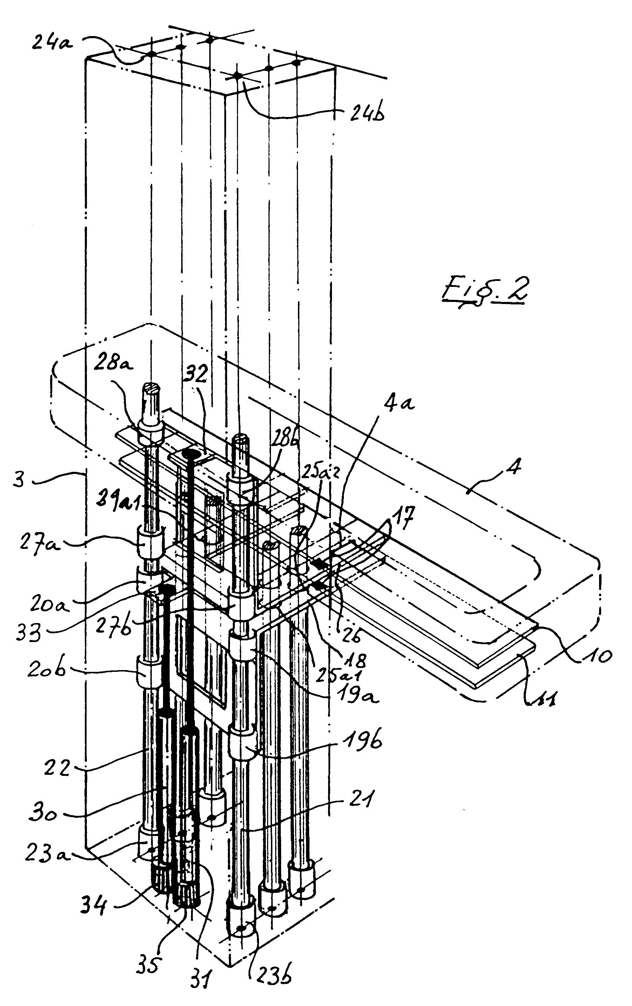

Le figure 2 est une vue/en perspective transparente du caisson porte console montrant partiellement les mécanismes de translation des plateaux qui sont les deux derniers dans la représentation du dessin.

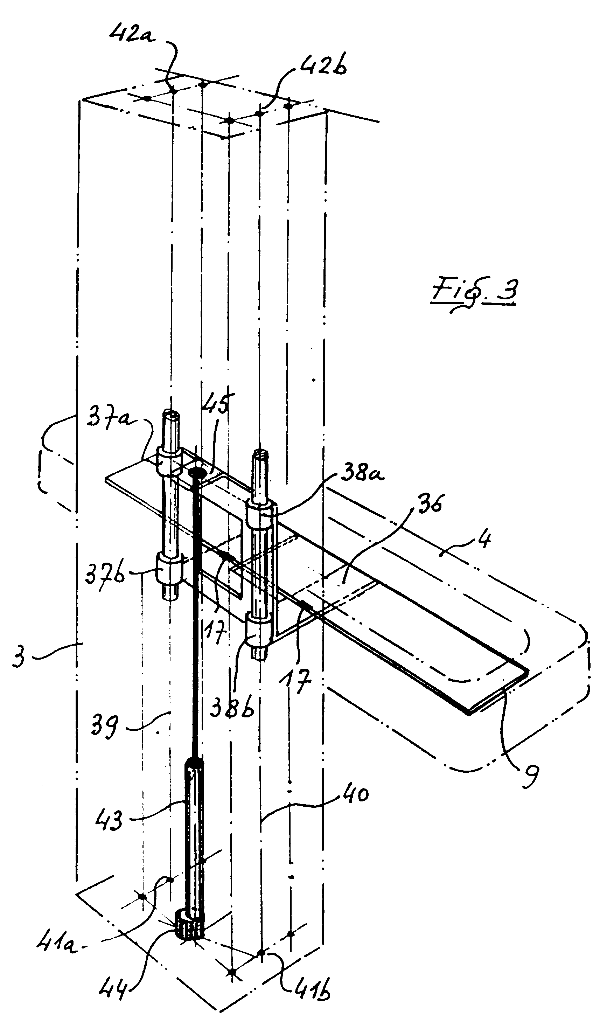

Le figure 3 est une vue en perspective transparente du caisson porte console montrant partiellement les mecanismes de translation des plateaux.(Le deuxième dans la représentation du dessin)

La figure 4 est une vue en perspective transparente du caisson porte console montrant partiellement les mécanismes de translation des plateaux.(Le premeir dans la représentation du dessin)

La figure 5 est un schéma électrique permettant de comprendre comment les séquences de commande de déplacement des plateaux et des éléments corrélatifs de securité correspondants peuvent être mis en oeuvre.

SI l'on se repporte à la figure 1,on voit que la console formant table de travail comporte essentiellement une structure rigide repérée 1 dans son ensemble et qui comprend:une assise rigide stable 2, un caisson 3 un caisson de travail 4 et un réceptacle supérieur 5

L'assise peut comporter en outre des points d'ancrage au sol 6 ou des vis de calage.

Le caisson de travail 4 est évidé en 7 pour permettre la mise en place des plateaux de travail 8-9-10- et 11 dont il sere parlé ci-aprés.

Le plateau en cours d'équipement (Rep.8 sur le. dessin) affleure le plan de travail du caisson 4 de telle sorte que l'ensemble constitue un plan de travail continu dont la hauteur d'environ 0,85 m a été choisie en fonction des critéres ergonomiques en usage. De même le dégagement de la partie inférieure a été déterminé afin d'assurer le passage aisé des jambes.

La rigidité de l'ensemble a en outre été prévue de telle sorte que le caisson et le plateau puissent supporter une charge utile d'au moins 100 Kg.

Le champ opératoire de travail a de même été prévu pour que l'opératrice puisse accéder à toute la surface d'un plateau sans déplacement de son siége de même que son confort est complété par une barre d'appuis repose pieds 12.

On voit de la sorte que le positionnement des composants sur le plateau (qui peut comporter un assez grand nombre de circuits imprimés disposés côte à côte) est rendu le moins fastidieux possible pour l'opératrice,ce qui constitue l'un des points essentiels de l'invention.

Le caisson est complété enfin de boutons de commande 13-14-15-16 à la disposition de l'opératrice et dont les fonctions seront exposées par la suite.

Il est à noter des dispositifs de verrouillage des plateaux repérés 17.(non représentés car bien connus en eux-mêmes).

La figure 2 représente les divers mécanismes nécessaires à l'assujettissement des plateaux et à leur déplacement vertical vers le haut.

Cette figure 2 représente de fait les systèmes pour les plateaux 10 et 11 pour des raisons de clarté de lecture du dessin.

En premier lieu,le dernier plateau 11 est placé horizontalement sur une potence 18 puis fixé par le Dispositif 17.

La potence 18 reçoit en sa partie verticale vers le bas et en ses quatre coins,des paliers à billes 19a,19b 20a et 20b glissant sur des barres cylindriques rectilignes 21, 22 fixées rigidement au caisson 3 par des supports d'ancrage 23a, 23b, et 24a, 24b (non représentés en totalité).

En outre des trous de passage 25a1, 25a2 et 25b1, 25b2 (non représentés) assurent le passage des autres barres.

Le caisson de console 4 est rompu de chaque coté en 4a afin de permettre le passage de toutes les potences.

L'avant dernier plateau 10 est positionné de maniére analogue sur une potence 26 et les quatre paliers à billes 27a, 27b et 28a, 28b sont également disposés aux quatre coins de la partie montante de ladite console et sur les mêmes barres 21, 22 que pour le plateau 11 précédemment décrit.

De même des trous 29a1, 29a2, et 29b1, 29b2 assurent le passage des autres barres.

On peut voir de la sorte que lesdites potences peuvent se mouvoir avec précision et douceur lors de leur mouvement de déplacement des plateaux soit vers le haut soit vers le bas.

Les ensembles de glissement sont complétés d'un ensemble de commande de déplacement par vérins 30, 31 prenant appuis;d'une part sur des pattes 32, 33 solidaires des potences et d'autre part,sur le fond du caisson 3.

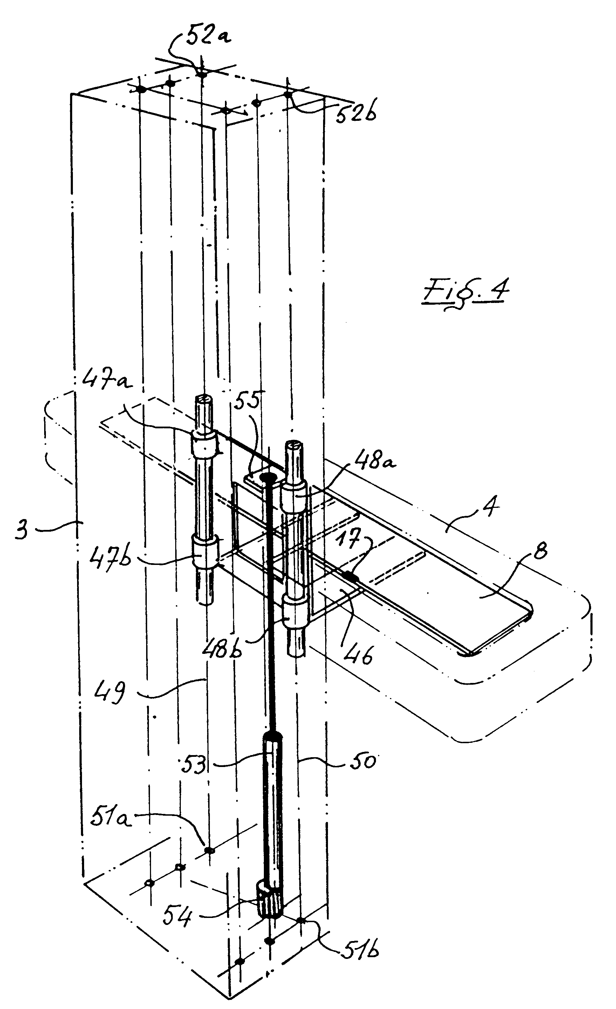

De même la figure 4 montre également un fonctionnement encore similaire du premier plateau 8 où l'on rencontre à cet effet,une potence 46 avec ses dispositifs de positionnement de plateaux 17,des paliers à billes 47a, 47b et 48a, 48b, des barres de guidage 49, 50 et des supports d'ancrage 51a, 51b, et 52a, 52b (ces barres et supports n'étant pas représentés sur le dessin)

L'équipement est complété par le vérin 53 (avec son moteur de commande 54) prenant appui sur la patte 53 solidaire de la potence 46 et sur le fond du caisson 3.

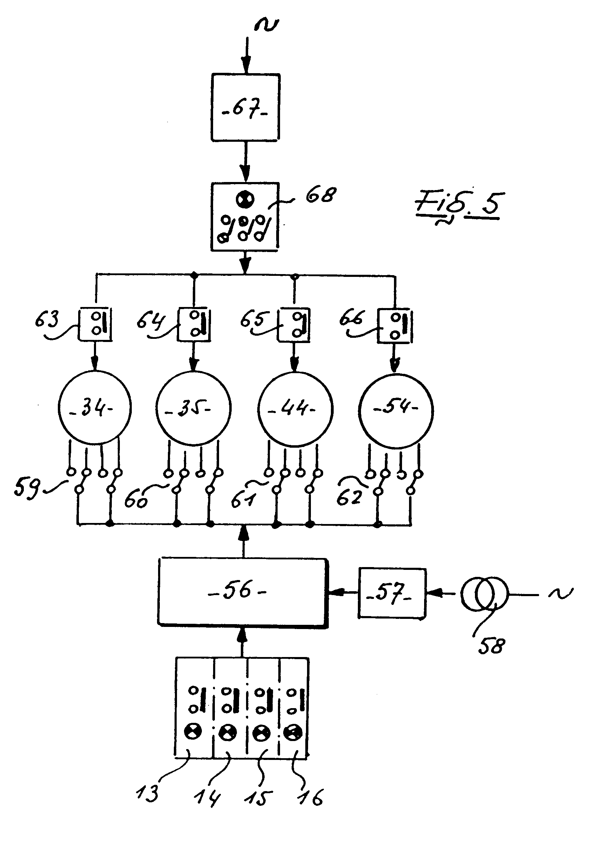

Le circuit électrique selon le schéma de la figure 5 comprend essentiellement : les quatre moteurs de vérin 34, 35, 44, 54 alimentés depuis une centrale d'asservissement utilisant la technologie dite "MOS" et repérée 56 dont l'alimentation régulée 57 est alimentée par le secteur à travers un transformateur 58.

Une série d'interrupteurs 59, 60, 61, 62 de fin de course assurent l'inversion des moteurs en fin de course des plateaux lors de la montée ou de la descente de ceux-ci.

De plus des détecteurs de surcharge pour la sécurité 63, 64, 65, 66 coupent l'alimentation desdits moteurs si une anomalie vient à se produire.

Enfin un circuit de protection général 67 et un commutateur de mise sous tension 68 complètent l'installation électrique.

En outre, des voyants lumineux signalent les opérations en cours selon l'usage.

Comme cela a été mentionné précédemment, les touches 13, 14, 15, 16 mises à la disposition de l'opératrice, assurent les mouvements de montée ou de descente des plateaux.

On note de la description qui précède, que la console de travail à déplacement vertical de tableaux logés soit dans un caisson de travail à conformation ergonomique soit dans un réceptacle supérieur, fournit bien les caractéristiques proposées par l'invention et qui visent, d'une part, une réduction de la surface d'occupation horizontale des circuits imprimés telle que rencontrée dans l'art antérieur et d'autre part, une amélioration du confort des opératrices qui trouvent dans leur champ d'action une surface de travail accessible sans déplacement.

Le nombre de plateaux peut être quelconque et pour n'importe quel usage.

On peut encore citer que la disposition des organes de commande peuvent être de toute nature telle que pédales en tout emplacement convenable.

**Revendications**

1. Console de travail ergonomique à plateaux mobiles verticalement, caractérisée en ce qu'elle comporte : une structure rigide (1) constituée d'une assise stable (2), d'un caisson (3) vertical, d'un caisson de travail (4), d'un réceptacle supérieur (5) et de la pluralité de plateaux (9, 10, 11, 12) disposés dans ledit caisson de travail et qui sont assujettis, par des potences (18, 26, 36, 46) liées en glissement à des barres verticales (21, 22, 39, 40, 49, 50) elles-mêmes fixées par des supports (23, 41, 51, 24, 42, 52) au caisson (3) vertical, de façon à effectuer à l'aide de mécanismes à vérins (30, 31, 43, 53) commandés par des moteurs (34, 35, 44, 54) des mouvements de translation verticale par glissement le long des barres verticales (21, 22, 39, 40, 49 50) à la demande de l'opératrice en vue soit de faire passer un plateau donné depuis la position de plan de travail jusqu'à la position de stockage dans le réceptacle supérieur (5), soit de faire passer un plateau donné depuis la position de stockage dans le réceptacle supérieur (5) jusqu'à la position de travail et ce pour tous les plateaux et à tous les stades opératoires.

2. Console de travail ergonomique à plateaux mobiles verticalement selon la revendication 1, caractérisée en ce que l'assujettissement en glissement de chaque potence aux barres (21, 22, 39, 40, 49, 50) s'effectue par quatre paliers à billes.

3. Console de travail ergonomique à plateaux mobiles verticalement selon la revendication 1, caractérisée en ce que les vérins (30, 31, 43, 53) sont du type électrique à vis à billes.

4. Console de travail ergonomique à plateaux mobiles verticalement selon la revendication 1, caractérisée en ce que les plateaux sont assujettis aux potences par des dispositifs de verrouillage (17) tels que clips, bien connus en eux-mêmes.

5. Console de travail ergonomique à plateaux mobiles verticalement selon la revendication 1, caractérisée en ce que des boutons de commande (13, 14, 15, 16) sont à la disposition de l'opérateur selon une conformation qui peut être adaptée pour un handicapé disposant par ailleurs, son fauteuil roulant sous le caisson de travail (4).

6. Console de travail ergonomique à plateaux mobiles verticalement selon la revendication 1, caractérisée en ce que la sécurité est assurée par des interrupteurs de fin de course (59, 60, 61, 62) et des détecteurs de surcharge (63, 64, 65, 66) tandis que le pilotage des automatismes est assuré par une centrale électronique d'asservissement (56) et alimentée par une alimentation régulée (57) servie par un transformateur (58).

7. Console de travail ergonomique à plateaux mobiles verticalement selon les revendications 1 à 6 caractérisée en ce que les plateaux, au nombre de quatre ou plus, supportent des circuits imprimés recevant des composants électroniques en attente de soudage ultérieur.

## Claims

1. Ergonomic work console with vertically moveable panels, characterized by the following: a rigid structure (1) consisting of a stable base plate (2), a caisson (3), a work caisson (4), an upper receptacle (5) and several trays (0, 10, 11, 12) fitted into the afore mentionned work caisson and fixed by brackets (18, 26, 36, 46) sliding onto stuts (21, 22, 39, 40, 49, 50) themselves fastened to supports (23, 41, 51, 24, 42, 52) to the caisson (3) to complete, via jack systems (30, 31, 43, 53) controlled by motors (34, 35, 44, 54), vertical movements as instructed by the operator either in order to transport a given tray from the work position to that of storage in the upper receptacle, or to transport a given tray from the storage position in the upper receptacle to the work position, this being possible for all the trays and at all stages in the operation.

2. Ergonomic work console with vertically moveable panels, as in claim 1, characterized by the sliding connection of each bracket to the struts (21, 22, 39, 40, 49, 50) by four ball bearings.

3. Ergonomic work console with vertically moveable panels, as in claim 1, characterized by the fact that the jacks (30, 31, 43, 53) are of the electric ball screw type.

4. Ergonomic work console with vertically moveable panels, as in claim 1, characterized by the fact that the trays are connected to the brackets by such locking devices (17) as clips, which are well known themselves.

5. Ergonomic work console with vertically moveable panels, as in claim 1, characterized by the fact that the control buttons (13, 14, 15, 16) can be reached by the operator in a layout which can be adapted to suit a handicapped worker whose wheel chair can besides be fitted under the work caisson (4).

6. Ergonomic work console with vertically moveable panels, as in claim 1, characterized by the fact that the safety is guaranteed by limit switches (59, 60, 61, 62) and overload detectors (63, 64, 65, 66) and the automated control is ensured by a control station (56) operating on the MOS technology and connected to a regulated supply (57) fed by a transformer (58).

7. Ergonomic work console with vertically moveable panels, as in claim 1 to 6, characterized by the fact that the trays, numbering 4 or more, support printed circuits which can recei ve electronic components awaiting welding.

## Patentansprüche

1. Ergonomische Arbeitskonsole mit senkrecht beweglichen Platten, dadurch gekennzeichnet, dass sie folgende Teile umfasst : eine steife Struktur (1) mit einer stabilen Auflage (2), einem Kasten (3), einem Arbeitskasten (4), einer oberen Aufnahme (5) und mehreren Platten (9, 10, 11, 12), die in diesem Arbeitskasten untergebracht und durch Ausleger (18, 26, 36, 46) gleitend mit Stäben (21, 22, 39, 40, 49, 50) verbunden sind, die ihrerseits mit Halterungen (23, 41, 51, 24, 42, 52) an dem Kasten (3) befestigt sind, um mit Hilfe von Mechanismen mit Zylindern (30, 31, 43, 53), die durch Motoren (34, 35, 44, 54) angetrieben werden, auf Wunsch der Bedienungsperson senkrechte Querbewegungen auszuführen, um entweder eine bestimmte Platte aus der Lage der Arbeitsfläche bis in die Lage der Aufbewahrung in einem oberhalb liegenden Behälter oder eine bestimmte Platte aus der Lage der Aufbewahrung in dem oberhalb liegenden Behälter bis in die Arbeitslage zu verbringen, und dies fur alle Platten und in allen Betriebsstufen.

2. Ergonomische Arbeitskonsole mit senkrecht beweglichen Platten nach Anspruch 1, dadurch gekennzeichnet, dass die Einrichtung der Gleitbewegung jedes Auslegers an den Stäben (21, 22, 39, 40, 49, 50) mit Hilfe von Kugellagern erfolgt.

3. Ergonomische Arbeitskonsole mit senkrecht beweglichen Platten nach Anspruch 1, dadurch gekennzeichnet, dass die Zylinder (30, 31, 43, 53) elektrisch und mit einer Kugelschnecke arbeiten.

4. Ergonomische Arbeitskonsole mit senkrecht beweglichen Platten nach Anspruch 1, dadurch gekennzeichnet, dass die Platten an den Auslegern mit Verriegelungsvorrichtungen (17) wie zum Beispiel an sich bekannte Clips befestigt werden.

5. Ergonomische Arbeitskonsole mit senkrecht beweglichen Platten nach Anspruch 1, dadurch gekennzeichnet, dass die Steuerknöpfe (13, 14, 15, 16) der Bedienungsperson in einer Anordnung zur Verfügung stehen, die sich für einen Körperbehinderten so anpassen lässt, dass er seinen Rollstuhl auch unter den Arbeitskasten (4) fahren kann.

6. Ergonomische Arbeitskonsole mit senkrecht beweglichen Platten nach Anspruch 1, dadurch gekennzeichnet, dass die Sicherheit durch Endlaufschalter (59, 60, 61, 62) und Vorrichtungen zum Feststellen einer Überlast (63, 64, 65, 66) gewährleistet wird, während die Steuerung der Automatikanlagen durch eine Steuerzentrale (56) erfolgt, die die als "MOS" bezeichnete Technik verwenden, und durch eine aus einem Transformator (58) kommende geregelte Einspeisung (57) versorgt wird.

7. Ergonomische Arbeitskonsole mit senkrecht beweglichen Platten nach Ansprüchen 1 bis 6, dadurch gekennzeichnet, dass die Platten, vier Stück an der Zahl oder mehr, gedruckte Schaltkreise tragen, die die Elektronikbauteile tragen, die später verlötet werden sollen.

_Fig. 1_

_Fig. 2_

*Fig. 3*

_Fig. 4_

_Fig. 5_